# EUROPEAN PATENT SPECIFICATION

(11) **EP 4 379 302 B1**
(45) Date of publication and mention of the grant of the patent: **26.11.2025**
(21) Application number: 22848166.9
(22) Date of filing: 27.06.2022
(51) Int. Cl.: F25D 23/12, F25D 11/00, F25D 31/00, A23L 5/30, B08B 3/12, F25D 17/04, F25D 29/00, G01N 29/14, G01N 29/44, G01N 29/48, G01N 29/30, G01N 29/34, G01N 29/36

(54) **REFRIGERATOR AND FAULT DETECTION METHOD FOR ULTRASOUND-ASSISTED PROCESSING DEVICE THEREOF**
KÜHLSCHRANK UND FEHLERERKENNUNGSVERFAHREN FÜR EINE ULTRASCHALLUNTERSTÜTZTE VERARBEITUNGSVORRICHTUNG DAFÜR
REFRIGERATEUR ET PROCÉDÉ DE DETECTION DE DÉFAUTS POUR DISPOSITIF DE TRAITEMENT ASSISTE PAR ULTRASONS

(30) Priority: 28.07.2021 CN 202110857405
(43) Date of publication of application: 05.06.2024
(73) Proprietor: Qingdao Haier Refrigerator Co., Ltd., Laoshan District Qingdao Shandong 266101 (CN); Haier Smart Home Co., Ltd., Qingdao, Shandong 266101 (CN)
(72) Inventor: ZHAO, Bintang, Qingdao, Shandong 266101 (CN); ZHANG, Peng, Qingdao, Shandong 266101 (CN); WANG, Jing, Qingdao, Shandong 266101 (CN); WANG, Liyan, Qingdao, Shandong 266101 (CN)
(74) Representative: Winter, Brandl - Partnerschaft mbB
(86) International application number: PCT/CN2022/101624
(87) International publication number: WO 2023/005559

(56) References cited:
- CN-A- 103 962 642
- CN-A- 107 835 723
- CN-A- 110 196 080
- CN-A- 110 542 722
- CN-U- 203 380 707
- CN-U- 205 718 153
- US-A- 4 579 000
- US-A1- 2008 209 650
- LUO XIAONING, ZHANYING ZHOU, QUN CAO, YULI ZHANG: "Design and Application of Piezoelectric Sensor in Ultrasonic Vibration System", INSTRUMENT TECHNIQUE AND SENSOR, no. 6, 1 January 2002 (2002-01-01), pages 6 - 7, XP093028498

## Description

### TECHNICAL FIELD

The present invention relates to the technical field of refrigerators, and in particularly to a refrigerator and a fault detection method for an ultrasound-assisted processing device thereof.

### BACKGROUND ART

Currently, an ultrasonic food processing apparatus is mainly used for cleaning food or accelerating pickling and freezing of the food, so as to improve the food processing efficiency.

CN 110 542 722 A discloses a fault detection method and device of an ultrasonic probe. The method comprises the following steps: acquiring actual charging time required to achieve predetermined target voltage by the voltage output by a to-be-detected array unit beginning from the charging on the to-be-detected array unit of the ultrasonic probe; acquiring an actual parameter according to the actual charging time, and detecting whether the actual parameter is consistent with the standard parameter, wherein the standard parameter is used for representing that the array unit is free from fault, and the types of the actual parameter and the standard parameter are same; if the actual parameter is consistent with the standard parameter, judging that the to-be-detected array unit is free from the fault; or judging that the to-be-detected array unit is in fault. Through the fault detection method provided by embodiment of the invention, the full-automation of the whole judgment process can be realized, the misjudgment or subjectivity caused by a manual operation can be avoided, so that a fault judgment result is more objective and accurate.

CN 205 718 153 U discloses a frostless refrigerator of ultrasonic wave and super hydrophobic material coupling defrosting, wherein the frostless refrigerator includes a main control unit, an evaporating chamber, a freezing chamber, a refrigerating chamber, a compressor, a drainage device, an environment temperature sensor and a magnetism controlled ventilation door, wherein the main control unit respectively connects the ultrasonic oscillation system, the compressor, an electric heater, the magnetism controlled ventilation door, a fan, the environment temperature sensor, a freezing chamber temperature sensor, an evaporimeter temperature sensor and a refrigerating chamber temperature sensor, wherein the ultrasonic oscillation system and the electric heater are defroster, the super hydrophobic material is adopted on all surfaces of the evaporimeter, a freezer wind channel, a freezer return air inlet, a refrigerating chamber wind channel and a refrigerating chamber air return duct. The utility model discloses a super hydrophobic material which handles the surface of frosting, adopts ultrasonic wave and electrical heating coupling, and does not shut down online defrosting, thereby guaranteeing the stable operating environment of refrigerator and increasing the service life.

In the prior art, an ultrasonic food processing apparatus operates using open-loop control. Some devices also have a frequency tracking circuit to track and adjust the frequency of the ultrasound generator in real time.

However, in the case of a plurality of ultrasonic transducers connected in parallel, the tracking circuit is unable to accurately sense the operating status of all of the ultrasonic transducers. For example, when damage occurs to only one of the ultrasonic transducers, it is not able to be detected in time to enable effective treatment, and it may result in a wider range of damage to or loss of components, and therefore improvement is still needed.

### SUMMARY OF THE INVENTION

In a first aspect, an objective of the present invention is to detect whether a first ultrasonic transducer has a fault, and to take immediate effective action when a fault in the first ultrasonic transducer is detected.

In the first aspect, a further objective of the present invention is to generate a fault code to identify the number of the first ultrasonic transducers that are faulty.

In a second aspect, an objective of the present invention is to provide a refrigerator.

Particularly, according to the first aspect of the present invention, the present invention provides a fault detecting method for an ultrasound-assisted processing device of a refrigerator. The ultrasound-assisted processing device includes multiple first ultrasonic transducers set in parallel, the multiple first ultrasonic transducers are used for receiving driving signals sent by an ultrasonic generator, and generating ultrasonic vibrations for targeted food materials; and a second ultrasonic transducer for generating an actual induced voltage from the ultrasonic vibrations; the fault detecting method includes:
obtaining the actual induced voltage produced by the second ultrasonic transducer;
comparing the actual induced voltage with a standard induced voltage;
if the actual induced voltage is less than the standard induced voltage, disconnecting the power supply of the ultrasonic generator.

Alternatively, the step of obtaining the actual induced voltage produced by the second ultrasonic transducer includes:
obtaining sample values from a collection device connected to the second ultrasonic transducer, and using the sample values as the actual induced voltage produced by the second ultrasonic transducer.

Alternatively, the standard induced voltage is set based on the voltage produced by the second ultrasonic transducer when all the first ultrasonic transducers are functioning normally.

Alternatively, after disconnecting the power supply of the ultrasonic generator, the method further includes:
generating a fault code based on the difference between the actual induced voltage and the standard induced voltage, and the fault code indicates the number of the first ultrasonic transducer which is faulty.

Alternatively, after generating the fault code based on the difference between the actual induced voltage and the standard induced voltage, the method further includes:
displaying the fault code on a display interface of the refrigerator and controlling a buzzer of the refrigerator to emit a fault alert sound.

Alternatively, after comparing the actual induced voltage with the standard induced voltage, the method further includes:
if the actual induced voltage is equal to the standard induced voltage, accumulating a total processing time of the ultrasound-assisted processing device, and shutting down the ultrasound-assisted processing device when the total processing time reaches a preset processing time.

Alternatively, the step of accumulating the total processing time of the ultrasound-assisted processing device includes:
starting a timer while running the ultrasound-assisted processing device;
obtaining a total timing time of the timer;
using the total timing time of the timer as the total processing time of the ultrasound-assisted processing device.

According to the second aspect of the present invention, a refrigerator is provided. The refrigerator includes:
an ultrasound-assisted processing device, including multiple first ultrasonic transducers and a second ultrasonic transducer, the multiple first ultrasonic transducers are set in parallel, the multiple first ultrasonic transducers are used for receiving driving signals sent by an ultrasonic generator for generating ultrasonic vibrations for processing targeted food materials, the second ultrasonic transducer is used for generating an induced voltage from the ultrasonic vibrations; and
a controller, including a memory and a processor, the controller is configured to implement any one of the fault detecting methods for the ultrasound-assisted processing device described above.

Alternatively, the ultrasound-assisted processing device further includes:
a tray, set within a storage compartment of the refrigerator;
the second ultrasonic transducer is located in the center of the bottom of the tray;
the multiple first ultrasonic transducers are arranged around the second ultrasonic transducer at the bottom of the tray.

Alternatively, the ultrasonic generator is connected with a first wire and a second wire, and two terminals of each first ultrasonic transducer are connected with the first wire and the second wire respectively.

According to the fault detection method of the ultrasound-assisted processing device of the present invention, upon discovering that the working process of the multiple first ultrasonic transducers causes the second ultrasonic transducer to produce actual induced voltage, compares the actual induced voltage with the standard induced voltage. When the actual induced voltage is found to be less than the standard induced voltage, it indicates that there is a fault in the first ultrasonic transducer. At this point, by automatically disconnecting the power supply of the ultrasonic generator, the operation of the first ultrasonic transducer is stopped, effectively preventing further damage to the faulty first ultrasonic transducer.

Further, in this embodiment, the fault code is generated based on the difference between the actual induced voltage and the standard induced voltage, with different differences representing different numbers of the faulty first ultrasonic transducers, and can therefore be effectively differentiated.

The aforesaid and other objectives, advantages and features of the present invention will be more apparent to those skilled in the art from the following detailed description of the specific embodiments of the present invention with reference to the accompanying drawings.

### BRIEF DESCRIPTION OF THE DRAWINGS

Various other advantages and benefits will be apparent to those of ordinary skill in the art by reading detailed descriptions of the preferred embodiments below. The accompanying drawings are only for the purpose of illustrating the preferred embodiments and shall not be construed as limitations to the present invention. In addition, the same reference numbers are used to represent the same components throughout the drawings, in which:
FIG. 1 is a schematic structural diagram of a refrigerator according to an embodiment of the present invention;
FIG. 2 is a schematic structural diagram of an ultrasound-assisted processing device according to an embodiment of the present invention;
FIG. 3 is a schematic block diagram of the refrigerator according to the embodiment of the present invention;
FIG. 4 is a schematic diagram of a fault detection method for an ultrasound-assisted processing device according to an embodiment of the present invention; and
FIG. 5 is a flowchart of the fault detection method for the ultrasound-assisted processing device according to the embodiment of the present invention.

### DETAILED DESCRIPTION

Exemplary embodiments of the present disclosure will be described in more detail below with reference to the accompanying drawings. However, although the exemplary embodiments of the present disclosure are shown in the drawings, it should be understood that the present disclosure may be implemented in various ways and shall not be limited by the embodiments set forth herein. On the contrary, these embodiments are provided for more thorough understanding of the present disclosure, and can fully convey the scope of the present disclosure to those skilled in the art.

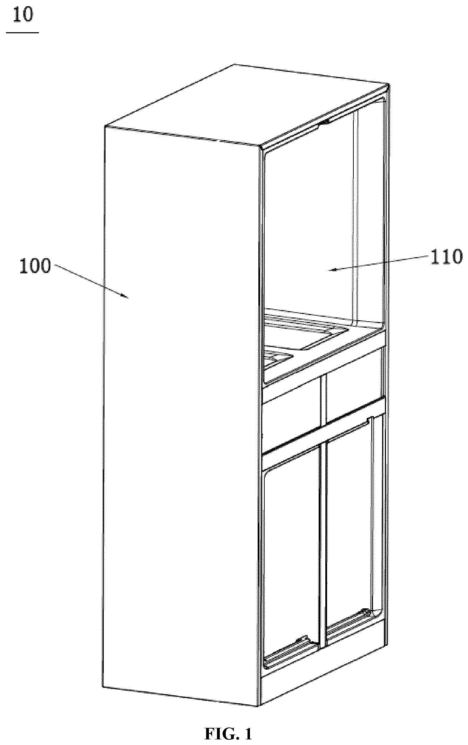

In order to solve the above problem, the present invention provides a refrigerator 10. FIG. 1 is a schematic structural diagram of the refrigerator 10 according to an embodiment of the present invention. The refrigerator 10 may generally include a cabinet 100, and one or more storage compartments 110 are formed in the cabinet 100. The storage compartments 110 may be configured to form a refrigerated storage space, a frozen storage space, a variable temperature storage space and the like according to refrigerating temperatures. Specifically, the number, functions and layout of the storage compartments 110 may be configured as required.

According to the present invention, the refrigerator 10 may further include an ultrasound-assisted processing device 200 (not shown in FIG. 1). In this embodiment, the ultrasound-assisted processing device 200 is located within the refrigerated storage space of the refrigerator 10. Of course, in other cases, the ultrasound-assisted processing device 200 can also be located within the frozen storage space or the variable temperature storage space. The functions of the ultrasound-assisted processing device 200 include, but are not limited to, assisting in pickling, freezing and the like. The ultrasound-assisted processing device 200 can be mounted in the form of a drawer in the refrigerated storage space or directly placed in the refrigerated storage space.

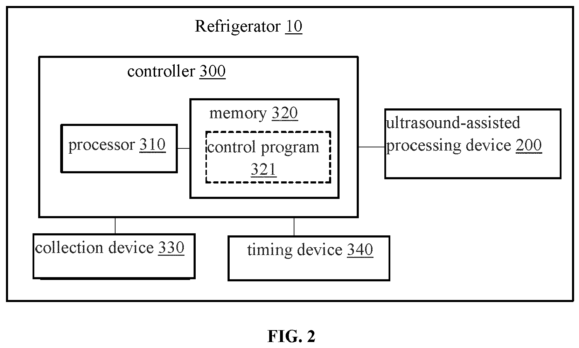

FIG. 2 is a schematic structural diagram of the ultrasound-assisted processing device 200 according to an embodiment of the present invention. Referring to FIG. 2, the ultrasound-assisted processing device 200 includes at least an ultrasonic generator 230, multiple first ultrasonic transducers 210, and a second ultrasonic transducer 220. The ultrasonic generator 230 can be located at the back of the refrigerator 10 for sending driving signals. The multiple first ultrasonic transducers 210 are set in parallel, each receiving ultrasonic signals sent by the ultrasonic generator 230, thereby generating ultrasonic vibrations for the target food materials. The second ultrasonic transducer 220 is not for receiving driving signals from the ultrasonic generator 230, but for generating actual induced voltage from the ultrasonic vibrations produced by the multiple first ultrasonic transducers 210.

Further, the ultrasound-assisted processing device 200 also includes a tray 240 set in the storage compartment 110. In this embodiment, the tray 240 is made of stainless steel metal material. The second ultrasonic transducer 220 can be located at the central outer bottom of the tray 240. The multiple first ultrasonic transducers 210 can be set around the second ultrasonic transducer 220 at the outer bottom of the tray 240, so that the ultrasonic vibrations generated by the multiple first ultrasonic transducers 210 during operation can be more fully transmitted to the second ultrasonic transducer 220.

In an optional embodiment, there can be four first ultrasonic transducers 210, arranged in an array on the outer bottom side of the tray 240. The second ultrasonic transducer 220 is located at the center of the four first ultrasonic transducers 210 and fixed to the tray 240.

In this embodiment, the ultrasonic generator 230 is connected with a first wire 231 and a second wire 232. The two terminals of each first ultrasonic transducer 210 are respectively connected with the first wire 231 and the second wire 232, that is, four second ultrasonic transducers 220 are set in parallel and work independently.

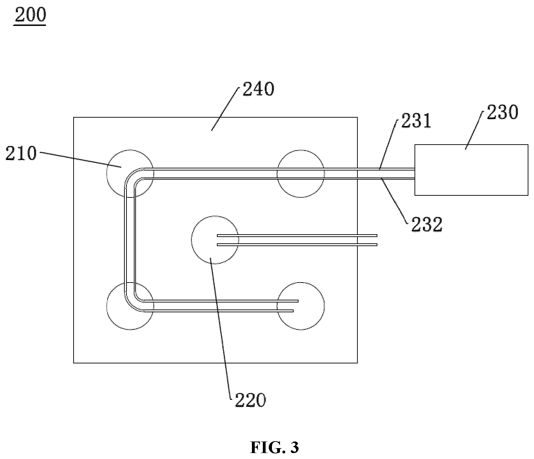

FIG. 3 is a schematic block diagram of the refrigerator 10 according to the embodiment of the present invention. Furthermore, the refrigerator 10 may also be equipped with a controller 300, a collection device 330, a timing device 340, and the like.

The controller 300 includes a memory 320 and a processor 310, and a control program 321 is stored in the memory 320. The control program 321, when executed by the processor 310, is configured to implement a fault detection method for the ultrasound-assisted processing device 200 according to this embodiment. The controller 300 is connected to the power supply signal of the ultrasonic generator 230 and starts and stops the ultrasonic generator 230 via the power supply. The controller 300 can be integrated on a main control board of the refrigerator 10 or set separately near the ultrasonic generator 230. The controller 300 further can be signal-connected with a main control device of the refrigerator 10, providing the working status of the ultrasonic generator 230 to the main control device and receiving control commands from the main control device.

The controller 300 may be implemented by various devices with certain data processing capabilities. In a typical configuration, the controller 300 may include a memory 320, a processor 310, an input/output interface, and the like.

The collection device 330 can be integrated on a computer control board of the refrigerator 10 and electrically connected to the second ultrasonic transducer 230 for collecting the actual induced voltage of the second ultrasonic transducer 230. The timing device 340 is used to accumulate the processing time of the ultrasound-assisted processing device 200, so as to timely shut down the ultrasound-assisted processing device 200 when its processing time reaches a preset processing time of the food materials.

It can be understood that the first ultrasonic transducer 210 is made of piezoelectric ceramics. When it fails, such as cracking, if it continues to work, more extensive cracking will occur, leading to the scrapping or danger of the first ultrasonic transducer 210. Therefore, to solve this problem, this embodiment adds the second ultrasonic transducer 220. The induced voltage generated by the second ultrasonic transducer 220 is used to determine whether there are faults in the multiple first ultrasonic generators 230, so that timely maintenance or replacement can be carried out on the faulty first ultrasonic transducer 210.

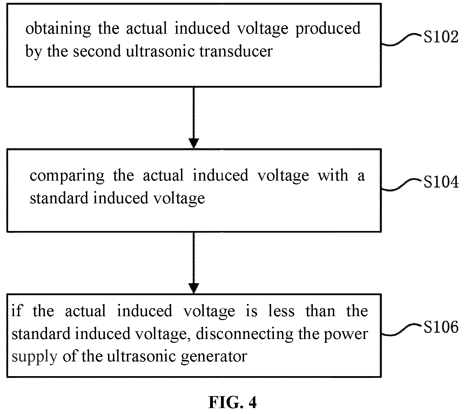

FIG. 4 is a schematic diagram of a fault detection method for an ultrasound-assisted processing device 200 according to an embodiment of the present invention. Referring to FIG. 4, the fault detection method at least includes steps S102 to S106 as follows.

In step S102, obtaining the actual induced voltage produced by the second ultrasonic transducer 220.

In step S104, comparing the actual induced voltage with the standard induced voltage.

In step S106, disconnecting the power supply of the ultrasonic generator 230 if the actual induced voltage is less than the standard induced voltage.

It should be noted that there are only two possible relationships between the actual induced voltage and the standard induced voltage: the first is when all the first ultrasonic transducers 210 are in normal working condition, the actual induced voltage is equal to the standard induced voltage; the second is when at least one of the multiple first ultrasonic transducers 210 has a fault, the actual induced voltage is less than the standard induced voltage, and the more the number of first ultrasonic transducers 210 with faults, the smaller the actual induced voltage. As the amplitude of the first ultrasonic transducers 210 does not change during the working process, there will not be a situation where the actual induced voltage is greater than the standard induced voltage. If the amplitude of the first ultrasonic transducers 210 is increased, a new standard induced voltage will also be set as a measurement standard.

The fault detection method of the ultrasound-assisted processing device 200 of the present invention, upon discovering that the working process of the multiple first ultrasonic transducers causes the second ultrasonic transducer 220 to produce actual induced voltage, compares the actual induced voltage with the standard induced voltage. When the actual induced voltage is found to be less than the standard induced voltage, it indicates that there is a fault in the first ultrasonic transducer. At this point, by automatically disconnecting the power supply of the ultrasonic generator 230, the operation of the first ultrasonic transducer is stopped, effectively preventing further damage to the faulty first ultrasonic transducer.

As described in step S102 above, the step of obtaining the actual induced voltage produced by the second ultrasonic transducer 220 can be obtaining the sample values from the collection device 330 and using these values as the actual induced voltage produced by the second ultrasonic transducer 220. The collection device 330 can be integrated on the computer control board of the refrigerator 10 and electrically connected to the second ultrasonic transducer 220.

The standard induced voltage is set according to the voltage value produced by the second ultrasonic transducer 220 when all the first ultrasonic transducers 210 are working normally. Also, when the amplitudes of all the first ultrasonic transducers 210 are simultaneously increased or decreased, the voltage value of the standard induced voltage will also increase or decrease accordingly.

In step S106 above, after disconnecting the power supply of the ultrasonic generator 230, a fault code can also be generated based on the difference between the actual induced voltage and the standard induced voltage. The fault code can be used to indicate the number of the first ultrasonic transducers 210 that are faulty. For example, if there are four first ultrasonic transducers 210, and all are working normally, the standard induced voltage is 2.5V. If one first ultrasonic transducer 210 is faulty, the actual induced voltage produced by the second ultrasonic transducer 220 is 2.0V; if two first ultrasonic transducers 210 are faulty, the actual induced voltage produced by the second ultrasonic transducer 220 is 1.5V; if three are faulty, the actual induced voltage produced by the second ultrasonic transducer 220 is 1V; if all four first ultrasonic transducers 210 are faulty, the actual induced voltage produced by the second ultrasonic transducer 220 is 0V. Since different fault codes are generated for different differences between the actual induced voltage and the standard induced voltage, the number of the faulty first ultrasonic transducers 210 can be effectively differentiated.

Furthermore, after generating a fault code based on the difference between the actual induced voltage and the standard induced voltage, it is also possible to further display the fault code on the display interface of the refrigerator 10 and controlling the buzzer of the refrigerator 10 to emit a fault alert sound. This allows staff to promptly understand the fault situation and repair or replace the faulty first ultrasonic transducer 210.

In a preferred embodiment, after comparing the actual induced voltage with the standard induced voltage, if the actual induced voltage is equal to the standard induced voltage, indicating that all the first ultrasonic transducers 210 are in a normal working state, the total processing time of the ultrasound-assisted processing device 200 is accumulated. When the total processing time of the ultrasound-assisted processing device 200 reaches the preset processing time, the ultrasound-assisted processing device 200 is shut down. The preset processing time here refers to the time required for the food materials to be continuously processed until completion. When the total processing time of the ultrasound-assisted processing device 200 reaches the preset processing time, it indicates that the food materials are essentially processed, and at this point, the ultrasound-assisted processing device 200 can be shut down.

The step of accumulating the total processing time of the ultrasound-assisted processing device 200 can be accomplished by starting a timer while running the ultrasound-assisted processing device 200, obtaining the total timing time of the timer, and using the total timing time of the timer as the total processing time of the ultrasound-assisted processing device 200. This method is relatively simple and convenient and easy to operate.

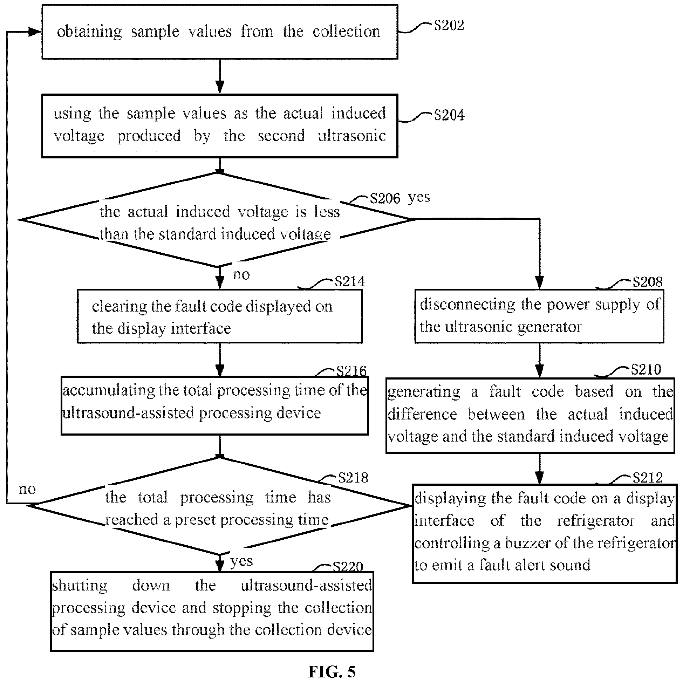

FIG. 5 is a flowchart of the fault detection method for the ultrasound-assisted processing device 200 according to the embodiment of the present invention. Referring to FIG. 5, the fault detection method at least includes steps S202 to S220 as follows.

In step S202, obtaining sample values from the collection device 330.

In this step, the collection device 330, which can be integrated into the computer control board of the refrigerator 10, is electrically connected to the second ultrasonic transducer 220.

In step S204, using the sample values as the actual induced voltage produced by the second ultrasonic transducer 220.

In step S206, determining whether the actual induced voltage is less than the standard induced voltage. If so, step S208 is executed; otherwise, step S214 is performed.

In this step, there are only two possible relationships between the actual induced voltage and the standard induced voltage: the first is when all the first ultrasonic transducers 210 are in normal working condition, the actual induced voltage is equal to the standard induced voltage; the second is when at least one of the multiple first ultrasonic transducers 210 has a fault, the actual induced voltage is less than the standard induced voltage, and the more the number of first ultrasonic transducers 210 with faults, the smaller the actual induced voltage. As the amplitude of the first ultrasonic transducers 210 does not change during the working process, there will not be a situation where the actual induced voltage is greater than the standard induced voltage. If the amplitude of the first ultrasonic transducers 210 is increased, a new standard induced voltage will also be set as a measurement standard.

In step S208, disconnecting the power supply of the ultrasonic generator 230.

In step S210, generating a fault code based on the difference between the actual induced voltage and the standard induced voltage.

In this step, different fault codes are generated for different differences between the actual induced voltage and the standard induced voltage, with each fault code indicating a different number of the faulty first ultrasonic transducers 210.

In step S212, displaying the fault code on a display interface of the refrigerator 10 and controlling a buzzer of the refrigerator 10 to emit a fault alert sound. This step allows staff to be alerted to timely repair or replace the faulty first ultrasonic transducer 210.

In step S214, clearing the fault code displayed on the display interface.

In this step, it should be noted that the fault code is generated in the event of faults in the multiple ultrasonic transducers to assist the staff in repair or replacement. After repairs or replacements are completed, if no faults in the first ultrasonic transducer 210 are detected upon re-detecting, the fault code displayed on the display interface are cleared. If no fault code was generated in the previous detecting process, there would be no fault code displayed on the interface during this execution process, and step S214 could be skipped, proceeding directly to step S216.

In step S216, accumulating the total processing time of the ultrasound-assisted processing device 200.

In step S218, determining whether the total processing time of the ultrasound-assisted processing device 200 has reached a preset processing time. If yes, step S220 is executed; if not, the process returns to step S202.

In this step, the preset processing time refers to the time required for the food materials to be continuously processed until completion. When the total processing time of the ultrasound-assisted processing device 200 reaches the preset processing time, indicating that the food materials are essentially processed, the ultrasound-assisted processing device 200 can be shut down.

In step S220, shutting down the ultrasound-assisted processing device 200 and stopping the collection of sample values through the collection device 330.

Through the actual use of prototype samples, the fault detecting method for the refrigerator 10 and its ultrasound-assisted processing device 200 in this embodiment can timely detect the presence of the faulty first ultrasonic transducers 210. It immediately disconnects the power supply of the ultrasonic generator 230, preventing potential hazards due to the cracking of the first ultrasonic transducers 210.

Therefore, those skilled in the art should appreciate that although multiple exemplary embodiments of the present invention have been illustrated and described in detail, many other variations or modifications that accord with the principle of the present invention may be still determined or derived directly from the content disclosed by the present invention. The present invention is defined by the appended claims.

## Claims

1. A fault detecting method for an ultrasound-assisted processing device (200) of a refrigerator (10), wherein the ultrasound-assisted processing device (200) comprises multiple first ultrasonic transducers (210) set in parallel, the multiple first ultrasonic transducers (210) are used for receiving driving signals sent by an ultrasonic generator (230), and generating ultrasonic vibrations for targeted food materials; and a second ultrasonic transducer (220) for generating an actual induced voltage from the ultrasonic vibrations; the fault detecting method comprises:
obtaining the actual induced voltage produced by the second ultrasonic transducer (220);
comparing the actual induced voltage with a standard induced voltage;
if the actual induced voltage is less than the standard induced voltage, disconnecting the power supply of the ultrasonic generator (230).

2. The fault detecting method for the ultrasound-assisted processing device (200) according to claim 1, wherein the step of obtaining the actual induced voltage produced by the second ultrasonic transducer (220) comprises:
obtaining sample values from a collection device (330) connected to the second ultrasonic transducer (220), and using the sample values as the actual induced voltage produced by the second ultrasonic transducer (220).

3. The fault detecting method for the ultrasound-assisted processing device (200) according to claim 1, wherein the standard induced voltage is set based on the voltage produced by the second ultrasonic transducer (220) when all the first ultrasonic transducers (210) are functioning normally.

4. The fault detecting method for the ultrasound-assisted processing device (200) according to any one of claims 1-3, wherein after disconnecting the power supply of the ultrasonic generator (230), the method further comprises:
generating a fault code based on the difference between the actual induced voltage and the standard induced voltage, and the fault code indicates the number of the first ultrasonic transducer (210) which is faulty.

5. The fault detecting method for the ultrasound-assisted processing device (200) according to claim 4, wherein after generating the fault code based on the difference between the actual induced voltage and the standard induced voltage, the method further comprises:
displaying the fault code on a display interface of the refrigerator (10) and controlling a buzzer of the refrigerator (10) to emit a fault alert sound.

6. The fault detecting method for the ultrasound-assisted processing device (200) according to any one of claims 1-3, wherein after comparing the actual induced voltage with the standard induced voltage, the method further comprises:
if the actual induced voltage is equal to the standard induced voltage, accumulating a total processing time of the ultrasound-assisted processing device (200), and shutting down the ultrasound-assisted processing device (200) when the total processing time reaches a preset processing time.

7. The fault detecting method for the ultrasound-assisted processing device (200) according to claim 6, wherein the step of accumulating the total processing time of the ultrasound-assisted processing device (200) comprises:
starting a timer while running the ultrasound-assisted processing device (200);
obtaining a total timing time of the timer;
using the total timing time of the timer as the total processing time of the ultrasound-assisted processing device (200).

8. A refrigerator (10), comprising:
an ultrasound-assisted processing device (200), comprising multiple first ultrasonic transducers (210) and a second ultrasonic transducer (220), the multiple first ultrasonic transducers (210) are set in parallel, the multiple first ultrasonic transducers (210) are used for receiving driving signals sent by an ultrasonic generator (230) for generating ultrasonic vibrations for processing targeted food materials, the second ultrasonic transducer (220) is used for generating an induced voltage from the ultrasonic vibrations; and
a controller (300), comprising a memory (320) and a processor (310), the controller (300) is configured to implement the fault detecting method for the ultrasound-assisted processing device (200) according to any one of claims 1-7.

9. The refrigerator (10) according to claim 8, wherein the ultrasound-assisted processing device (200) further comprises:
a tray (240), set within a storage compartment (110) of the refrigerator (10);
the second ultrasonic transducer (220) is located in the center of the bottom of the tray (240);
the multiple first ultrasonic transducers (210) are arranged around the second ultrasonic transducer (220) at the bottom of the tray (240).

10. The refrigerator (10) according to claim 8, wherein the ultrasonic generator (230) is connected with a first wire (231) and a second wire (232), and two terminals of each first ultrasonic transducer (210) are connected with the first wire (231) and the second wire (232) respectively.

## Patentansprüche

1. Fehlererkennungsverfahren für eine ultraschallgestützte Verarbeitungsvorrichtung (200) eines Kühlschranks (10), wobei die ultraschallgestützte Verarbeitungsvorrichtung (200) mehrere erste Ultraschallwandler (210), die parallel geschaltet sind, wobei die mehreren ersten Ultraschallwandler (210) zum Empfangen von Antriebssignalen, die von einem Ultraschallgenerator (230) gesendet werden, und zum Erzeugen von Ultraschallschwingungen für gezielte Lebensmittelmaterialien verwendet werden; und einen zweiten Ultraschallwandler (220) zum Erzeugen einer tatsächlichen induzierten Spannung aus den Ultraschallschwingungen aufweist; wobei das Fehlererkennungsverfahren Folgendes umfasst:
Erhalten der tatsächlichen induzierten Spannung, die von dem zweiten Ultraschallwandler (220) erzeugt wird;
Vergleichen der tatsächlichen induzierten Spannung mit einer standardmäßigen induzierten Spannung;
wenn die tatsächliche induzierte Spannung kleiner als die standardmäßige induzierte Spannung ist, Trennen der Stromversorgung des Ultraschallgenerators (230).

2. Fehlererkennungsverfahren für die ultraschallgestützte Verarbeitungsvorrichtung (200) nach Anspruch 1, wobei der Schritt von dem Erhalten der tatsächlichen induzierten Spannung, die von dem zweiten Ultraschallwandler (220) erzeugt wird, Folgendes umfasst:
Erhalten von Abtastwerten von einer Sammelvorrichtung (330), die mit dem zweiten Ultraschallwandler (220) verbunden ist, und Verwenden der Abtastwerte als die tatsächliche induzierte Spannung, die von dem zweiten Ultraschallwandler (220) erzeugt wird.

3. Fehlererkennungsverfahren für die ultraschallgestützte Verarbeitungsvorrichtung (200) nach Anspruch 1, wobei die standardmäßige induzierte Spannung basierend auf der Spannung eingestellt wird, die von dem zweiten Ultraschallwandler (220) erzeugt wird, wenn alle der ersten Ultraschallwandler (210) normal funktionieren.

4. Fehlererkennungsverfahren für die ultraschallgestützte Verarbeitungsvorrichtung (200) nach einem der Ansprüche 1 bis 3, wobei das Verfahren nach dem Trennen der Stromversorgung des Ultraschallgenerators (230) ferner Folgendes umfasst:
Erzeugen eines Fehlercodes basierend auf der Differenz zwischen der tatsächlichen induzierten Spannung und der standardmäßigen induzierten Spannung, und wobei der Fehlercode die Anzahl der ersten Ultraschallwandler (210) angibt, die fehlerhaft ist.

5. Fehlererkennungsverfahren für die ultraschallgestützte Verarbeitungsvorrichtung (200) nach Anspruch 4, wobei das Verfahren nach dem Erzeugen des Fehlercodes basierend auf der Differenz zwischen der tatsächlichen induzierten Spannung und der standardmäßigen induzierten Spannung ferner Folgendes umfasst:
Anzeigen des Fehlercodes auf einer Anzeigeschnittstelle des Kühlschranks (10) und Steuern eines Summers des Kühlschranks (10), um einen Fehleralarmton auszugeben.

6. Fehlererkennungsverfahren für die ultraschallgestützte Verarbeitungsvorrichtung (200) nach einem der Ansprüche 1 bis 3, wobei das Verfahren nach dem Vergleichen der tatsächlichen induzierten Spannung mit der standardmäßigen induzierten Spannung ferner Folgendes umfasst:
wenn die tatsächliche induzierte Spannung gleich der standardmäßigen induzierten Spannung ist, Akkumulieren einer Gesamtverarbeitungszeit der ultraschallgestützten Verarbeitungsvorrichtung (200) und Abschalten der ultraschallgestützten Verarbeitungsvorrichtung (200), wenn die Gesamtverarbeitungszeit eine vorbestimmte Verarbeitungszeit erreicht.

7. Fehlererkennungsverfahren für die ultraschallgestützte Verarbeitungsvorrichtung (200) nach Anspruch 6, wobei der Schritt des Akkumulierens der Gesamtverarbeitungszeit der ultraschallgestützten Verarbeitungsvorrichtung (200) Folgendes umfasst:
Starten eines Timers, während des Betriebs der ultraschallgestützten Verarbeitungsvorrichtung (200);
Erhalten einer Gesamtzeitdauer des Timers;
Verwenden der Gesamtzeitdauer des Timers als die Gesamtverarbeitungszeit der ultraschallgestützten Verarbeitungsvorrichtung (200).

8. Kühlschrank (10), mit:
einer ultraschallgestützten Verarbeitungsvorrichtung (200), die mehrere erste Ultraschallwandler (210) und einen zweiten Ultraschallwandler (220) aufweist, wobei die mehreren ersten Ultraschallwandler (210) parallel geschaltet sind, wobei die mehreren ersten Ultraschallwandler (210) zum Empfangen von Antriebssignalen, die von einem Ultraschallgenerator (230) gesendet werden, und zum Erzeugen von Ultraschallschwingungen zum Verarbeiten gezielter Lebensmittelmaterialien verwendet werden, wobei der zweite Ultraschallwandler (220) zum Erzeugen einer induzierten Spannung aus den Ultraschallschwingungen verwendet wird; und
einer Steuerung (300), die einen Speicher (320) und einen Prozessor (310) aufweist, wobei die Steuerung (300) eingerichtet ist, das Fehlererkennungsverfahren für die ultraschallgestützte Verarbeitungsvorrichtung (200) nach einem der Ansprüche 1 bis 7 zu implementieren.

9. Kühlschrank (10) nach Anspruch 8, wobei die ultraschallgestützte Verarbeitungsvorrichtung (200) ferner Folgendes aufweist:
eine Ablage (240), die in einem Aufbewahrungsfach (110) des Kühlschranks (10) angeordnet ist;
wobei der zweite Ultraschallwandler (220) in der Mitte des Bodens der Ablage (240) angeordnet ist;
wobei die mehreren ersten Ultraschallwandler (210) um den zweiten Ultraschallwandler (220) an dem Boden der Ablage (240) angeordnet sind.

10. Kühlschrank (10) nach Anspruch 8, wobei der Ultraschallgenerator (230) mit einem ersten Draht (231) und einem zweiten Draht (232) verbunden ist und zwei Anschlüsse jedes ersten Ultraschallwandlers (210) jeweils mit dem ersten Draht (231) und dem zweiten Draht (232) verbunden sind.

## Revendications

1. Procédé de détection de défaut pour un dispositif de traitement assisté par ultrasons (200) d'un réfrigérateur (10), dans lequel le dispositif de traitement assisté par ultrasons (200) comprend de multiples premiers transducteurs à ultrasons (210) montés en parallèle, les multiples premiers transducteurs à ultrasons (210) sont utilisés pour recevoir des signaux d'entraînement envoyés par un générateur d'ultrasons (230), et générer des vibrations ultrasonores pour des aliments ciblés ; et un second transducteur à ultrasons (220) pour générer une tension induite réelle à partir des vibrations ultrasonores ; le procédé de détection de défaut comprend :
l'obtention de la tension induite réelle produite par le second transducteur à ultrasons (220) ;
la comparaison de la tension induite réelle avec une tension induite standard ;
si la tension induite réelle est inférieure à la tension induite standard, la déconnection de l'alimentation électrique du générateur d'ultrasons (230).

2. Procédé de détection de défaut pour le dispositif de traitement assisté par ultrasons (200) selon la revendication 1, dans lequel l'étape d'obtention de la tension induite réelle produite par le second transducteur à ultrasons (220) comprend :
l'obtention de valeurs d'échantillon à partir d'un dispositif de collecte (330) connecté au second transducteur à ultrasons (220), et utiliser les valeurs d'échantillon comme tension induite réelle produite par le second transducteur à ultrasons (220).

3. Procédé de détection de défaut pour le dispositif de traitement assisté par ultrasons (200) selon la revendication 1, dans lequel la tension induite standard est définie sur la base de la tension produite par le second transducteur à ultrasons (220) lorsque tous les premiers transducteurs à ultrasons (210) fonctionnent normalement.

4. Procédé de détection de défaut pour le dispositif de traitement assisté par ultrasons (200) selon l'une quelconque des revendications 1-3, dans lequel, après avoir déconnecté l'alimentation électrique du générateur d'ultrasons (230), le procédé comprend en outre :
la génération d'un code de défaut basé sur la différence entre la tension induite réelle et la tension induite standard, et le code de défaut indique le numéro du premier transducteur à ultrasons (210) qui est défectueux.

5. Procédé de détection de défaut pour le dispositif de traitement assisté par ultrasons (200) selon la revendication 4, dans lequel après la génération du code de défaut sur la base de la différence entre la tension induite réelle et la tension induite standard, le procédé comprend en outre :
l'affichage du code d'erreur sur une interface d'affichage du réfrigérateur (10) et commander un avertisseur du réfrigérateur (10) pour émettre un son d'alerte de défaut.

6. Procédé de détection de défaut pour le dispositif de traitement assisté par ultrasons (200) selon l'une quelconque des revendications 1-3, dans lequel, après comparaison de la tension induite réelle avec la tension induite standard, le procédé comprend en outre :
si la tension induite réelle est égale à la tension induite standard, l'accumulation d'un temps de traitement total du dispositif de traitement assisté par ultrasons (200), et arrêter le dispositif de traitement assisté par ultrasons (200) lorsque le temps de traitement total atteint un temps de traitement prédéfini.

7. Procédé de détection de défaut pour le dispositif de traitement assisté par ultrasons (200) selon la revendication 6, dans lequel l'étape d'accumulation du temps de traitement total du dispositif de traitement assisté par ultrasons (200) comprend :
le démarrage d'un chronomètre pendant le fonctionnement du dispositif de traitement assisté par ultrasons (200) ;
l'obtention d'un temps de chronométrage total du chronomètre ;
l'utilisation du temps de chronométrage total du chronomètre comme temps de traitement total du dispositif de traitement assisté par ultrasons (200).

8. Réfrigérateur (10), comprenant :
un dispositif de traitement assisté par ultrasons (200), comprenant de multiples premiers transducteurs à ultrasons (210) et un second transducteur à ultrasons (220), les multiples premiers transducteurs à ultrasons (210) étant montés en parallèle, les multiples premiers transducteurs à ultrasons (210) étant utilisés pour recevoir des signaux d'entraînement envoyés par un générateur d'ultrasons (230) pour générer des vibrations ultrasonores pour le traitement d'aliments ciblés, le second transducteur à ultrasons (220) étant utilisé pour générer une tension induite à partir des vibrations ultrasonores ; et
un dispositif de commande (300), comprenant une mémoire (320) et un processeur (310), le dispositif de commande (300) est configuré pour mettre en œuvre le procédé de détection de défaut pour le dispositif de traitement assisté par ultrasons (200) selon l'une quelconque des revendications 1-7.

9. Réfrigérateur (10) selon la revendication 8, dans lequel le dispositif de traitement assisté par ultrasons (200) comprend en outre :
un plateau (240), monté dans un compartiment de rangement (110) du réfrigérateur (10) ;
le second transducteur à ultrasons (220) est situé au centre du fond du plateau (240) ;
les multiples premiers transducteurs à ultrasons (210) sont agencés autour du second transducteur à ultrasons (220) au niveau du fond du plateau (240).

10. Réfrigérateur (10) selon la revendication 8, dans lequel le générateur d'ultrasons (230) est connecté à un premier fil (231) et à un second fil (232), et deux bornes de chaque premier transducteur à ultrasons (210) sont connectées respectivement au premier fil (231) et au second fil (232).
